# EUROPÄISCHE PATENTSCHRIFT

(11) **EP 2 046 608 B1**
(45) Veröffentlichungstag und Bekanntmachung des Hinweises auf die Patenterteilung: **12.05.2010**
(21) Anmeldenummer: 07785676.3
(22) Anmeldetag: 24.07.2007
(51) Int. Cl.: B60R 25/04, H03K 17/97

(54) **KONTAKTLOSER SCHALTER**
CONTACTLESS SWITCH
COMMUTATEUR SANS CONTACT

(30) Priorität: 31.07.2006 DE 102006035514; 18.11.2006 DE 102006054412
(43) Veröffentlichungstag der Anmeldung: 15.04.2009
(73) Patentinhaber: Conti Temic microelectronic GmbH, 90411 Nürnberg (DE)
(72) Erfinder: DEININGER, Jochen, 88048 Friedrichshafen (DE); REINWALD, Martin, 88682 Salem/Weildorf (DE)
(86) Internationale Anmeldenummer: PCT/DE2007/001313
(87) Internationale Veröffentlichungsnummer: WO 2008/014757

(56) Entgegenhaltungen:
- DE-A1- 19 747 720
- DE-A1- 19 821 899
- DE-A1- 19 938 888

## Beschreibung

Die Erfindung betrifft einen kontaktlosen Schalter, insbesondere einen Drehschalter zur Verwendung als elektronisches Zündschloss.

Ein solches elektronisches Zündschloß ist in der Druckschrift DE 199 38 888 A1 beschrieben.

Herkömmliche, kontaktbehaftete Schalter, beispielsweise Zündschlösser von Kraftfahrzeugen unterliegen bei häufigem Gebrauch Verschleiß an ihren Kontakten infolge Reibung, elastischer Verformung, Stromfluss und Abrissfunken. Zündschlösser weisen gewöhnlich Vorrichtungen auf, die erkennen, ob ein Zündschlüssel gesteckt oder abgezogen ist. Diese Erkennung findet normalerweise auf mechanischem Wege statt und führt zu einer Blockierung der Lenkung oder der Aufhebung dieser Blockierung. Im Hinblick auf in modernen Fahrzeugen vorhandene elektronische Systeme, eine verbesserte Fahrberechtigungskontrolle und in der Zukunft zu erwartende Drive-by-Wire Systeme, bei denen eine mechanische Lenkung möglicherweise entfällt, ist es wünschenswert, auch die Erkennung, ob der Schlüssel gesteckt oder abgezogen ist, elektronisch und ebenfalls kontaktlos vorzunehmen.

Der Erfindung liegt daher die Aufgabe zugrunde, einen kontaktlosen Schalter anzugeben.

Die Aufgabe wird erfindungsgemäß gelöst durch einen kontaktlosen Schalter mit den Merkmalen des Anspruchs 1.

Vorteilhafte Ausgestaltungen der Erfindung sind Gegenstand der Unteransprüche.

Ein erfindungsgemäßer kontaktloser Schalter umfasst einen angular und/oder axial verstellbaren Rotor, durch den zumindest ein Hauptmagnet direkt oder indirekt verstellbar ist, dessen Magnetfeld mindestens zwei Magnetfeldsensoren beeinflusst, durch die mit einer magnetischen Feldstärke des Magnetfeldes und/oder einer Änderung der magnetischen Feldstärke und/oder einer Polarisierung des Magnetfeldes korrelierte Signale ausgebbar sind. Durch das Entfallen von elektrischen Kontakten werden damit verbundene Verschleißerscheinungen vermieden. Insbesondere ist der Rotor angular und axial verstellbar, also drehbar und in Richtung einer Drehachse verschiebbar. Bei geschickter Anordnung der Magnetfeldsensoren ist eine Position des Rotors axial und angular mit denselben Magnetfeldsensoren bestimmbar, indem deren Signale von einer geeigneten Auswerteeinrichtung ausgewertet werden. Diese Auswerteeinrichtung kann dann auch die eigentlichen Schaltvorgänge mittels geeigneter Bauelemente, wie beispielsweise Transistoren, übernehmen.

Der kontaktlose Schalter ist mittels eines Schlüssels betätigbar. Zu diesem Zweck ist der Rotor so gestaltet, dass er den Schlüssel aufnehmen kann. Ein so gestalteter kontaktloser Schalter ist beispielsweise als Zündschloss einsetzbar, bei dem anhand der axialen Position des Rotors feststellbar ist, ob ein Schlüssel gesteckt oder abgezogen ist und bei der die angulare Position bestimmt, welche Klemmen (beispielsweise Stellung 0, Klemme 15, 15R, 50) mit Spannung zu versorgen sind.

Die Magnetfeldsensoren sind bevorzugt als Hallsensoren ausgebildet. Hallsensoren nutzen den nach Edwin Hall benannten Hall-Effekt. Ein stromdurchflossener Hall-Sensor liefert eine zum Produkt aus Stromstärke und magnetischer Feldstärke eines senkrecht zum Stromfluss verlaufenden Magnetfeldes proportionale Spannung, so dass bei bekannter Stromstärke die magnetische Feldstärke relativ genau bestimmt werden kann. Unter Berücksichtigung der von mehreren Hallsensoren gemessenen magnetischen Feldstärke desselben Hauptmagneten lässt dies eine hinreichend exakte Positionsbestimmung des Rotors zu. Hallsensoren sind aufgrund ihrer weiten Verbreitung kostengünstig verfügbar, insbesondere in Form mehrerer, in einer integrierten Schaltung integrierter Hallsensoren. In diesem Falle können die Signale aus den kombinierten Messwerten der magnetischen Feldstärke mehrerer Magnetfeld- bzw. Hallsensoren kombiniert sein.

Die Signale können kontinuierlich und/oder diskret in Zeit und/oder Wert ausgegeben werden. Diskrete Signale, die beispielsweise pulsweitencodiert und/oder seriell und/oder parallel ausgegeben werden können, sind von einer Auswerteeinrichtung mit geringerem Aufwand verarbeitbar als kontinuierliche, beschränken jedoch, verglichen mit diesen, die Genauigkeit der Positionsbestimmung. Eine Kombination mehrerer kontinuierlicher und/oder diskreter Varianten der Signalausgabe bietet aufgrund der damit verbundenen Redundanz eine Möglichkeit für die Auswerteeinrichtung, gegebenenfalls Störungen im kontaktlosen Schalter (magnetische Störfelder, Auseinanderbrechen eines Magneten) zu erkennen oder die Plausibilität der empfangenen Signale zu prüfen. Für eine diskrete Ausgabe der Signale werden in den Magnetfeldsensoren bzw. den diese enthaltenen integrierten Schaltungen entsprechende Quantisierungs- und/oder Kodierungseinrichtungen benötigt.

Als Auswerteeinrichtung kommt vorzugsweise ein Mikroprozessor in Betracht. Mikroprozessoren sind in einer Vielzahl für die unterschiedlichsten Einsatzzwecke kostengünstig verfügbar. Einige Modelle verfügen über Analog/Digital-Wandler-Eingänge, so dass sie die Auswertung kontinuierlicher Signale ohne zusätzliche Hardware übernehmen können.

In einer bevorzugten Ausführungsform sind vier Magnetfeldsensoren vorgesehen, die zueinander um 90° versetzt auf dem Umfang eines gedachten Kreises angeordnet sind. Ein um eine Drehachse drehbarer, als Rundmagnet oder Ringmagnet ausgebildeter Hauptmagnet mit diametral polarisiertem Magnetfeld, bei dem die Drehachse ungefähr in Normalrichtung des gedachten Kreises dessen Fläche im Bereich seines Mittelpunktes schneidet, erlaubt mit so angeordneten Magnetfeldsensoren eine Bestimmung von acht verschiedenen angularen Positionen des Hauptmagneten und damit des Rotors selbst dann, wenn nur die Polarität des Magnetfeldes in jedem der Magnetfeldsensoren bestimmt und die magnetische Feldstärke außer Acht gelassen wird. Die Berücksichtigung der magnetischen Feldstärke erlaubt eine noch wesentlich genauere Positionsbestimmung. Die Verwendung eines Ringmagneten erlaubt beispielsweise eine Infrarotkommunikation zwischen dem Schlüssel und einem Infrarot-Transceiver in Richtung der Drehachse.

Die Auswertung der magnetischen Feldstärke erlaubt weiter eine Bestimmung der axialen Position des Rotors, wenn durch eine Veränderung dieser axialen Position eine Veränderung des Abstandes des Hauptmagneten zu den Magnetfeldsensoren bewirkt wird. Ohne Änderung der Polarität verringert sich dabei die magnetische Feldstärke mit zunehmendem Abstand.

Erfindungsgemäß ist der Rotor koaxial in einem Hilfsrotor oder der Hilfsrotor koaxial in dem Rotor angeordnet. Der Rotor und der Hilfsrotor sind relativ zu den Magnetfeldsensoren und relativ zueinander angular und/oder axial verstellbar. Der Rotor und der Hilfsrotor weisen ineinander greifend ein Gewinde oder eine Kulisse auf, mit dem oder der eine axiale Verstellung des Rotors eine angulare Verstellung des Hilfsrotors bewirkt. Der Hilfsrotor dient als ein Verbindungsglied zur indirekten Verbindung des Hauptmagneten mit dem Rotor. Auf diese Weise bewirkt eine axiale Verstellung des Rotors, beispielsweise durch einen gesteckten oder abgezogenen Schlüssel eine Drehung des Hauptmagneten. Bei einem kontaktlosen Schalter wie einem Zündschloss, bei dem die möglichen angularen Positionen durch Anschläge beschränkt sind und die Anzahl zu unterscheidender angularer Positionen gering ist, ist diese Ausführungsform eine mechanisch besonders einfache und praktikable Lösung.

In einer weiteren Ausführungsform ist der Hauptmagnet um eine Drehachse des Rotors oder des Hilfsrotors oder um eine Hilfsachse drehbar gelagert. Die Magnetfeldsensoren sind auf einer Leiterplatte dem Hauptmagneten zugewandt oder abgewandt angeordnet. Bei dem Hauptmagneten zugewandter Anordnung ist ein Magnet mit relativ geringer magnetischer Feldstärke ausreichend. Liegen die Magnetfeldsensoren, beispielsweise aus Platzgründen, auf der vom Hauptmagneten abgewandten Seite der Leiterplatte benötigt dieser zur Durchdringung der Leiterplatte eine erhöhte magnetische Feldstärke. Weiterhin kann es aus Platzgründen erforderlich sein, den Hauptmagneten nicht direkt am Rotor oder Hilfsrotor, sondern seitlich davon um eine Hilfsachse drehbar anzuordnen.

Insbesondere in diesem Fall werden bzw. wird als weiteres Verbindungsglied ein Getriebe und/oder ein Hilfsmagnet verwendet, das die Verbindung des Hauptmagneten mit dem Rotor oder dem Hilfsrotor herstellt. Als Getriebe soll hier jede Art mechanischer Verbindung verstanden werden, die zur Übertragung von Rotations- und/oder Translationsbewegungen geeignet ist, im einfachsten Fall zwei miteinander kämmende Zahnräder, von denen eines auf der Drehachse und das andere auf der Hilfsachse angeordnet ist. Ebenso kann ein Hilfsmagnet auf der Drehachse vorgesehen sein, der, ebenfalls diametral polarisiert, die Drehung des Hauptmagneten um die zur Drehachse parallele oder damit fluchtende Hilfsachse bewirkt.

In einer weiteren Ausführungsform sind die Magnetfeldsensoren dem auf der Hilfsachse befestigten Hauptmagneten zugewandt. Der Hauptmagnet wird durch den um die Drehachse drehbaren Hilfsmagneten bewegt, wobei die Drehachse und die Hilfsachse in einer Flucht liegen und die Leiterplatte mit den Magnetfeldsensoren zwischen dem Hauptmagneten und dem Hilfsmagneten liegt. Hierfür ist eine reibungsarme Lagerung des Hauptmagneten bzw. der Hilfsachse vorzusehen.

Ausführungsbeispiele der Erfindung werden anhand einer Zeichnung näher erläutert. Darin zeigen:
- Fig. 1: eine perspektivische Ansicht eines kontaktlosen Schalters mit einem Rotor, einem Hilfsrotor, einem Hauptmagneten und einer integrierten Schaltung mit Magnetfeldsensoren,
- Fig. 2: eine integrierte Schaltung mit vier Magnetfeldsen- soren,
- Fig. 3: eine Darstellung einer Verteilung des magnetischen Feldes eines Rundmagneten,
- Fig. 4: eine schematische Draufsicht auf vier Magnetfeld- sensoren und einen Hauptmagneten in zwei verschie- denen angularen Positionen,
- Fig. 5: eine schematische seitliche Schnittansicht der An- ordnung aus Fig. 4 mit dem Hauptmagneten in zwei verschiedenen axialen Positionen,
- Fig. 6: eine schematische Seitenansicht einer auf einer Leiterplatte auf deren vom Hauptmagneten abgewand- ten Seite angeordneten integrierten Schaltung mit Magnetfeldsensoren,
- Fig. 7: zwei schematische Ansichten eines kontaktlosen Schalters, bei dem der auf einer Hilfsachse paral- lel zu einer Drehachse des Rotors angeordnete Hauptmagnet mit Hilfe zweier Zahnräder angetrieben ist,
- Fig. 8: zwei schematische Ansichten eines kontaktlosen Schalters, bei dem der auf einer Hilfsachse paral- lel zu der Drehachse des Rotors angeordnete Haupt- magnet mit Hilfe eines Hilfsmagneten angetrieben ist,
- Fig. 9: eine schematische Seitenansicht eines kontaktlosen Schalters, bei dem der auf einer Hilfsachse fluch- tend mit der Drehachse des Rotors angeordnete Hauptmagnet mit Hilfe eines Hilfsmagneten angetrie- ben ist,
- Fig. 10: ein Blockschaltbild einer Signalübertragung zwi- schen der integrierten Schaltung und einem Mikro- prozessor mit Wake-Up-Funktion,
- Fig. 11: ein Blockschaltbild einer Signalübertragung zwi- schen der integrierten Schaltung und einem Mikro- prozessor mit Wake-Up-Funktion unter Beteiligung eines System-Basis-Chips und
- Fig. 12: ein Blockschaltbild einer Signalübertragung zwi- schen der integrierten Schaltung und einem Mikro- prozessor mit Redundanz.

Einander entsprechende Teile sind in allen Figuren mit den gleichen Bezugszeichen versehen.

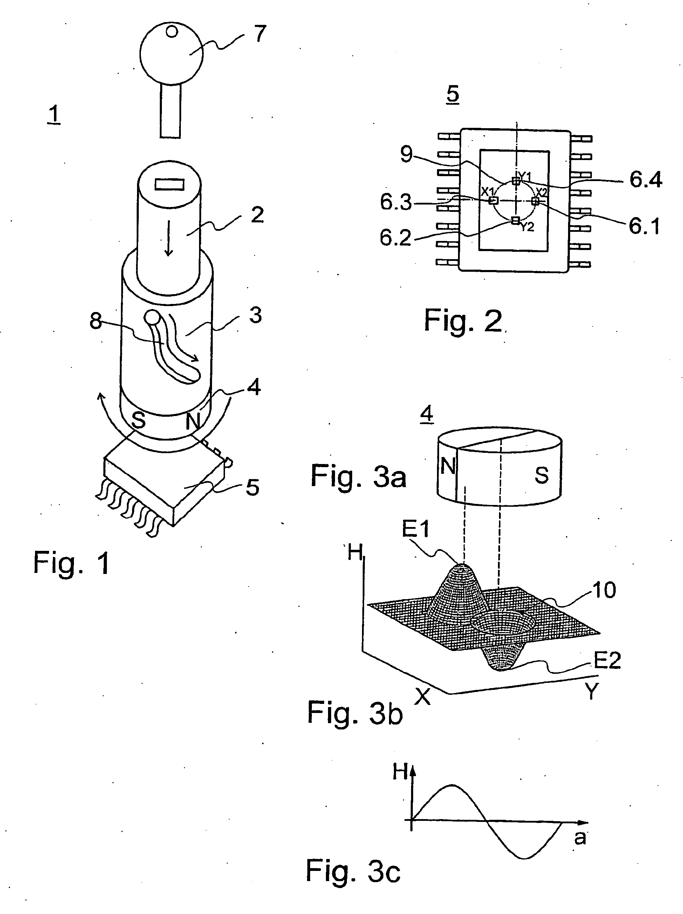

Fig. 1 zeigt eine perspektivische Ansicht eines kontaktlosen Schalters 1 mit einem Rotor 2, einem Hilfsrotor 3, einem Hauptmagneten 4 und einer integrierten Schaltung 5 mit Magnetfeldsensoren 6 (hier nicht dargestellt). Der Hauptmagnet 4 ist als ein Rundmagnet mit diametraler Polarisierung ausgebildet. Der Rundmagnet weist eine zylindrische Form auf. Die Pole N, S des Magnetfeldes F liegen einander auf einer zylindrischen Mantelfläche des Hauptmagneten 4 gegenüber. Die integrierte Schaltung 5 enthält mehrere Magnetfeldsensoren 6 zur Detektion dieses Magnetfeldes F, wie im Detail in den folgenden Figuren gezeigt wird. Der gezeigte kontaktlose Schalter 1 ist mit einem Schlüssel 7 bedienbar, der in den Rotor 2 eingesteckt werden kann. Hierdurch wird eine axiale Bewegung des Rotors 2 bewirkt. Der im Hilfsrotor 3 koaxial angeordnete Rotor 2 ist mit diesem durch eine Kulisse 8 verbunden, die bewirkt, dass die axiale Bewegung des Rotors 2 in eine angulare Bewegung des ebenso wie der Rotor 2 drehbar gelagerten Hilfsrotors 3 umgesetzt wird. Hierdurch dreht sich auch der im gezeigten Beispiel am Hilfsrotor 3 angeordnete Hauptmagnet 4, was durch die integrierte Schaltung 5 detektierbar ist. Auf die gleiche Weise ist eine infolge Drehung des Schlüssels 7 veränderbare angulare Position des Rotors 2 detektierbar. Um eine Unterscheidung angularer von axialen Positionsänderungen zu ermöglichen, können mechanische Rasten vorgesehen sein, die nur bestimmte angulare Positionen zulassen. Der gezeigte kontaktlose Schalter 1 ist auch ohne Schlüssel 7 mit einer anderen Art der Betätigung realisierbar. Er eignet sich beispielsweise als Zündschloss, als Lichtschalter, als Schalter zur Lenkwinkelerfassung oder Klimaanlagensteuerung, gegebenenfalls auch ohne axiale Positionserfassung. Der Hilfsrotor 3 kann alternativ koaxial im Rotor 2 angeordnet sein.

Fig. 2 zeigt die integrierte Schaltung 5 mit vier Magnetfeldsensoren 6.1 bis 6.4, die auf dem Umfang eines gedachten Kreises 9 angeordnet sind. Die Magnetfeldsensoren 6.1 bis 6.4 sind als Hallsensoren ausgebildet.

Die Figuren 3a bis c verdeutlichen die Verteilung des magnetischen Feldes F des in Figur 3a gezeigten als Rundmagnet ausgebildeten Hauptmagneten 4 in Richtung einer seiner Deckflächen. In Figur 3b ist die Verteilung der magnetischen Feldstärke H über einer durch die Raumkoordinaten X und Y aufgespannten Fläche, die der Deckfläche des Hauptmagneten 4 parallel liegt, gezeigt. Vorzugsweise wird ein Hauptmagnet 4 verwendet, dessen magnetisches Feld F Extrema E1, E2 auf dem Umfang eines Extremwertkreises 10 aufweist, der den gleichen Durchmesser wie der gedachte Kreis 9 hat, auf dessen Umfang die Magnetfeldsensoren 6.1 bis 6.4 angeordnet sind. Fig. 3c zeigt einen Graphen der magnetischen Feldstärke H auf einem Punkt des Umfangs des Extremwertkreises 10 in Abhängigkeit von einer durch einen Drehwinkel α beschriebenen angularen Position des Hauptmagneten 4.

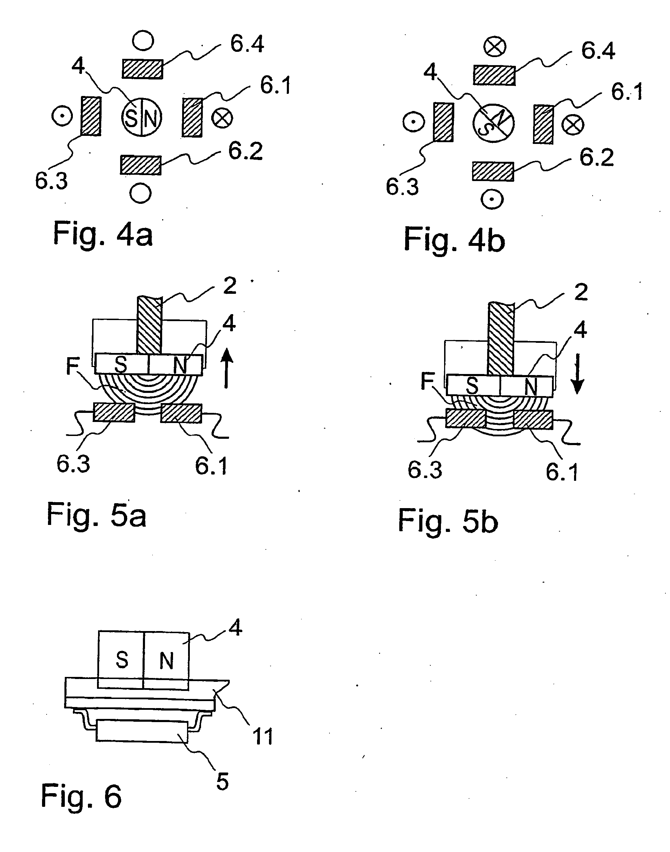

Die Figuren 4a und 4b zeigen je eine schematische Draufsicht auf vier Magnetfeldsensoren 6.1 bis 6.4 und einen Hauptmagneten 4 in zwei verschiedenen angularen Positionen. In Figur 4a weist der Nordpol N des Hauptmagneten 4 in Richtung des Magnetfeldsensoren 6.1, der Südpol entsprechend in die Gegenrichtung auf den Magnetfeldsensor 6.3. Die beiden übrigen Magnetfeldsensoren 6.2, 6.4 liegen jeweils in einem Bereich, in dem das magnetische Feld F, wie in den Nulldurchgängen des Graphen aus Figur 3c gezeigt, keine vertikale Komponente aufweist. Die angulare Position des Hauptmagneten 4 ist also allein anhand der Polarität des von den Magnetfeldsensoren 6.1 bis 6.4 gemessenen Magnetfeldes F eindeutig bestimmbar. In Richtung des Betrachters aus der Darstellung austretende Feldlinien des magnetischen Feldes F sind entsprechend der Konvention durch einen Punkt in einem Kreis, in Gegenrichtung verlaufende Feldlinien durch ein Kreuz in einem Kreis gekennzeichnet und exemplarisch neben den einzelnen Magnetfeldsensoren 6.1 bis 6.4 angezeigt. Ein leerer Kreis symbolisiert die Abwesenheit eines magnetischen Feldes. In Figur 4b ist der Hauptmagnet 4 um 45° im Gegenuhrzeigersinn verdreht, wodurch die Magnetfeldsensoren 6.1 und 6.4 ein magnetisches Feld F mit entgegen gesetzter Polarität zu dem von den Magnetfeldsensoren 6.2 und 6.3 detektierten messen. Auf diese Weise sind nur unter Berücksichtigung der Polarität des an jedem der Magnetfeldsensoren 6.1 bis 6.4 gemessenen Magnetfeldes F acht angulare Positionen des Hauptmagneten 4 unterscheidbar. Wird von jedem der Magnetfeldsensoren 6.1 bis 6.4 ein hinreichend genauer Wert der magnetischen Feldstärke H ermittelt, ist eine entsprechend genauere Bestimmung der angularen Position sowie auch des Abstandes des Hauptmagneten 4 von den Magnetfeldsensoren 6.1 bis 6.4, also seiner axialen Position, möglich.

Die Figuren 5a und 5b zeigen je eine schematische seitliche Schnittansicht der Anordnung aus Fig. 4 mit dem Hauptmagneten 4 in zwei verschiedenen axialen Positionen. Entsprechend sind nur zwei Magnetfeldsensoren 6.1 und 6.3 sichtbar. In Figur 5a befindet sich der Hauptmagnet 4 in einer von den Magnetfeldsensoren 6.1, 6.3 entfernteren axialen Position, in Figur 5b in einer axialen Position näher an den Magnetfeldsensoren 6.1, 6.3. In beiden Fällen ist die von den Magnetfeldsensoren 6.1, 6.3 ermittelte Polarität des Magnetfeldes F unverändert, jedoch ist bei der in Figur 5 b gezeigten Situation die jeweils gemessene magnetische Feldstärke H größer als bei der in Figur 5a gezeigten Situation, was durch die größere Anzahl von Feldlinien verdeutlicht wird, die durch die Magnetfeldsensoren 6.1, 6.3 hindurch verlaufen. Bei dieser Art der Ermittelung der axialen Position kann der Hauptmagnet 4 direkt am Rotor 2 befestigt sein, ohne dass ein Hilfsrotor 3 mit Kulisse 8 benötigt wird.

Fig. 6 zeigt eine schematische Seitenansicht einer auf einer Leiterplatte 11 auf deren vom Hauptmagneten 4 abgewandten Seite angeordneten integrierten Schaltung 5 mit Magnetfeldsensoren 6. Sofern eine Anordnung wie in den zuvor gezeigten Figuren 1, 4, 5 konstruktiv erschwert oder unmöglich ist, kann diese Ausführungsform gewählt werden. Die Dämpfung des magnetischen Feldes F durch die Leiterplatte 11 und dessen Leiterbahnen und -flächen ist durch einen entsprechend stärkeren Hauptmagneten 4 zu kompensieren. Die von den Magnetfeldsensoren 6.1 bis 6.4 detektierte angulare Position weist einen inversen Drehsinn auf.

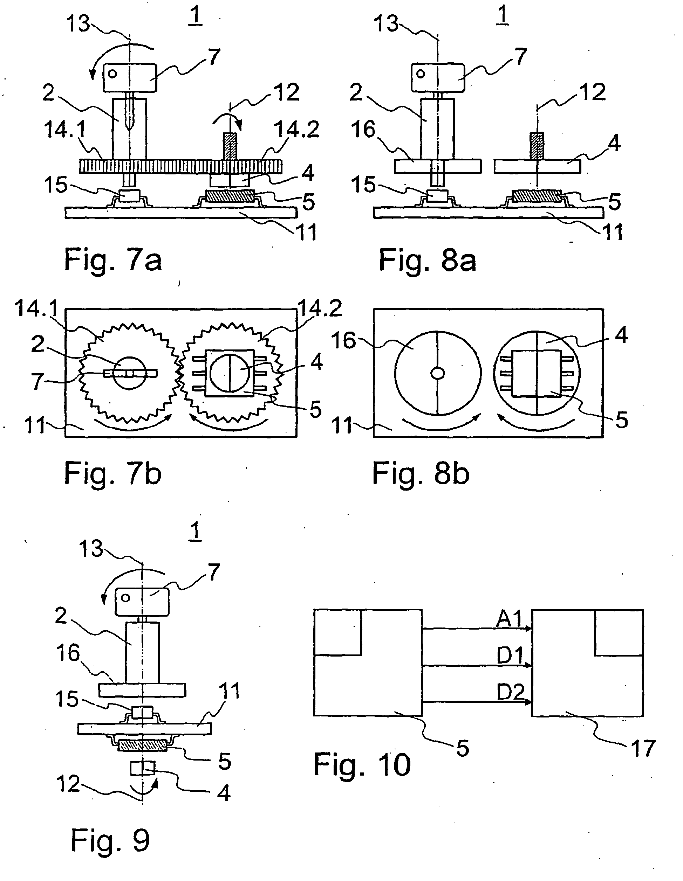

Fig. 7a zeigt eine schematische Seitenansicht eines erfindungsgemäßen kontaktlosen Schalters 1, bei dem der auf einer Hilfsachse 12 parallel zu einer Drehachse 13 des Rotors 2 angeordnete Hauptmagnet 4 mit Hilfe zweier Zahnräder 14.1, 14.2 angetrieben ist. Statt der Zahnräder 14.1, 14.2 ist auch eine andere Art von Getriebe, beispielsweise mit einer anderen Art von Zahnrädern, Winkeltrieben, Steuerketten oder Antriebsriemen denkbar. Ebenso wie in Figur 6 ist der von den in der integrierten Schaltung 5 angeordneten Magnetfeldsensoren 6.1 bis 6.4 detektierte Drehsinn der angularen Positionsänderung des Rotors 2 gegenüber diesem invertiert. In der gezeigten Darstellung befindet sich in der Verlängerung der Drehachse 13 auf der Leiterplatte 11 ein Infrarot-Transceiver 15 zur Kommunikation mit einem entsprechenden, im Schlüssel vorgesehenen Gegenstück (nicht gezeigt), wie er zur Identifizierung des Schlüssels 7, beispielsweise bei Zündschlössern, verwendet werden kann. Der Rotor weist hierzu im Bereich seiner Drehachse 13 eine Bohrung auf. Selbstverständlich ist die gezeigte Anordnung auch ohne den Infrarot-Transceiver 15 realisierbar. Figur 7b zeigt den kontaktlosen Schalter aus Figur 7a in einer Draufsicht. Das Zahnrad 14.2 ist in der Darstellung transparent, um die integrierte Schaltung 5 sichtbar zu machen.

Fig. 8a zeigt eine schematische Seitenansicht eines kontaktlosen Schalters 1, dessen Aufbau dem in den Figuren 7a und 7b gezeigten weitgehend entspricht. Die Übertragung der Drehbewegung zwischen der Drehachse 13 und der Hilfsachse 12 erfolgt hier jedoch statt über Zahnräder durch einen Hilfsmagneten 16, der ebenfalls diametral polarisiert, jedoch als Ringmagnet ausgebildet ist. Da sich die entgegengesetzten Polpaare des Hauptmagneten 4 und des Hilfsmagneten 16 anziehen, wird bei einer Drehbewegung des Rotors 2 mit dem Hilfsmagneten 16 auch der Hauptmagnet 4, wiederum gegenläufig, um die Hilfsachse 12 gedreht.

Fig. 9 zeigt eine schematische Seitenansicht einer weiteren Ausführungsform eines kontaktlosen Schalters 1, bei dem der Hauptmagnet 4 um eine Hilfsachse 12 drehbar angeordnet ist, die mit der Drehachse 13 des Rotors 2 fluchtet. Am Rotor 2 ist um die Drehachse 13 ein Hilfsmagnet 16 drehbar angeordnet, dessen Magnetfeld den Hauptmagneten 4 antreibt. Auch diese Ausführungsform erlaubt den Einsatz eines Infrarot-Transceivers 15 zur Kommunikation mit dem Schlüssel 7, sofern der Hauptmagnet 4 als Ringmagnet ausgebildet ist.

Fig. 10 zeigt ein Blockschaltbild einer Signalübertragung zwischen der integrierten Schaltung 5 und einem Mikroprozessor 17 mit Wake-Up-Funktion. Die integrierte Schaltung 5 wertet die Messwerte der Magnetfeldsensoren 6.1 bis 6.4 aus und übermittelt die ermittelte angulare und/oder axiale Position des Rotors 2 in Form eines kontinuierlichen Signals A1 und eines diskreten Signals D1. Zu diesem Zweck muss das vorliegende kontinuierliche A1 Signal in der integrierten Schaltung 5 quantisiert werden, beispielsweise mittels eines Analog/Digital-Umsetzers. Das diskrete Signal D1 kann beispielsweise pulsweitencodiert und/oder seriell und/oder parallel ausgegeben werden. Die Information aus den beiden Signalen A1, D1 ist weitgehend redundant. Auf diese Weise ist eine höhere Stör- und/oder Ausfallsicherheit möglich. Der Mikroprozessor 17, beispielsweise als Mikrokontroller ausgebildet, verfügt über Eingänge, die für den Empfang der Signale A1, D1 geeignet sind. Für das kontinuierliche Signal A1 ist ein im Mikroprozessor 17 integrierter Analog/Digital-Umsetzer erforderlich. Ein weiteres diskretes Signal D2 wird von der integrierten Schaltung 5 nur dann aktiviert, wenn eine Positionsänderung eingetreten ist. Es kann verwendet werden, um den Mikroprozessor 17 aus einem Strom-Spar-Modus zu wecken. Diese Funktion wird als Wake-Up-Funktion bezeichnet.

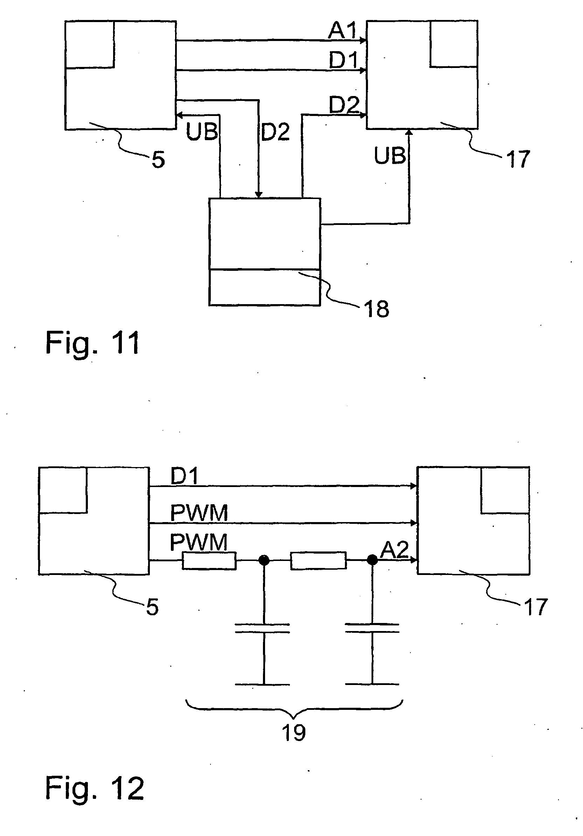

Fig. 11 zeigt ein Blockschaltbild einer Signalübertragung zwischen der integrierten Schaltung 5 und einem Mikroprozessor 17 mit Wake-Up-Funktion unter Beteiligung eines System-Basis-Chips 18. Der System-Basis-Chip 18 ist ein integrierter Schaltkreis für Standardfunktionen wie Spannungsversorgung und -regelung. Die Anordnung aus Figur 10 ist dadurch dahingehend ergänzt, dass sowohl die integrierte Schaltung 5 als auch der Mikroprozessor 17 vom System-Basis-Chip 18 mit einer Betriebsspannung UB versorgt werden und das Anlegen der Betriebsspannung UB an den Mikroprozessor 17 durch das die Wake-Up-Funktion ausführende diskrete Signal D2 ausgelöst wird. Der Mikroprozessor 17 verbraucht demzufolge nur dann Strom, wenn eine Positionsänderung des kontaktlosen Schalters 1 stattgefunden hat. Es ist auch möglich den Mikroprozessor 17 z. B. im Powerdown-Mode und/oder Sleep-Mode zu betreiben und durch das Signal D2 wieder aufzuwecken. Der Mikroprozessor 17 hat in diesen besonderen Betriebszuständen eine verminderte Stromaufnahme.

Fig. 12 zeigt ein Blockschaltbild einer redundanten Signalübertragung zwischen der integrierten Schaltung 5 und einem Mikroprozessor 17. In diesem Ausführungsbeispiel wird die Positionsinformation auf drei verschiedenen Wegen von der integrierten Schaltung 5 an den Mikroprozessor 17 übermittelt. Neben dem bereits bekannten diskreten Signal D1 wird in der integrierten Schaltung ein pulsweitencodiertes Signal PWM generiert, das zum einen direkt vom Mikroprozessor 17 empfangen wird, wo mittels Messung der Pulsweiten die Positionsinformation rekonstruiert wird. Zum anderen wird das pulsweitencodierte Signal PWM durch einen Tiefpass 19, z. B. zweiter Ordnung, integriert. Hierdurch kann bei einer integrierten Schaltung ohne separaten Analogausgang ein pulsweitenmodulierter Ausgang PWM mittels eines externen Tiefpasses 19 zum Analogsignal A2 gewandelt werden. Das dabei entstehende kontinuierliche Signal oder Analogsignal A2 wird im Mikroprozessor wiederum von einem dort integrierten Analog/DigitalUmsetzer quantisiert.

Der kontaktlose Schalter 1 ist unter anderem als elektronisches Zündschloss, als Lichtschalter oder zur Lenkwinkelerfassung oder Klimaanlagensteuerung geeignet.

Die in den Figuren 5a und 5b gezeigte Bestimmung der axialen Position ist mit einer Kulisse 8, wie in Figur 1 gezeigt, kombinierbar.

Statt einer Kulisse 8 ist auch eine andere Art der Umsetzung einer axialen in eine angulare Bewegung möglich, beispielsweise durch ein Gewinde.

Als Hauptmagnet 4 können andere Magnete statt Rund- oder Ringmagneten, insbesondere mit einer von der diametralen abweichenden Polarisierung verwendet werden.

Außer Hallsensoren können auch andere Magnetfeldsensoren 6.1 bis 6.n verwendet werden. Insbesondere müssen die Magnetfeldsensoren 6.1 bis 6.n nicht in einer integrierten Schaltung 5 integriert sein. Ihre Anzahl kann von vier abweichen.

Alternativ kann der Rotor 2 feststehend ausgebildet sein und ein nicht näher dargestellter Schieber verschoben werden. Dabei weist der Rotor 2 in einem solchen Ausführungsbeispiel einen axialen Schlitz auf, der Hilfsrotor 3 eine Kulisse und der Schieber seitlich z. B. zwei Zapfen auf.

Vorzugsweise wird der oben beschriebene kontaktlose Schalter 1 als elektronisches Zündschloss oder als Lichtschalter oder zur Lenkwinkelerfassung oder Klimaanlagensteuerung verwendet. Darüber hinaus kann der kontaktlose Schalter 1 auch für weitere alternative Funktionen oder Verwendungen, Systeme oder Vorrichtungen eingesetzt werden.

### Bezugszeichenliste

- 1: kontaktloser Schalter
- 2: Rotor
- 3: Hilfsrotor
- 4: Hauptmagnet
- 5: Integrierte Schaltung
- 6: Magnetfeldsensor
- 7: Schlüssel
- 8: Kulisse
- 9: Gedachter Kreis
- 10: Extremwertkreis
- 11: Leiterplatte
- 12: Hilfsachse
- 13: Drehachse
- 14: Zahnrad
- 15: Infrarot-Transceiver
- 16: Hilfsmagnet
- 17: Mikroprozessor
- 18: System-Basis-Chip
- 19: Tiefpass
- A1, A2: kontinuierliches Signal
- D1, D2: diskretes Signal
- α: Drehwinkel
- E: Extremum des magnetischen Feldes
- F: Magnetfeld
- H: magnetische Feldstärke
- N: Nordpol
- PWM: Pulsweitenmoduliertes Signal
- S: Südpol
- X, Y: Raumkoordinaten

## Patentansprüche

1. Kontaktloser Schalter (1), aufweisend
a) einen angular und/oder axial verstellbaren Rotor (2) mit einer Schlüsselaufnahme, wobei der Rotor (2) um eine Drehachse (13) drehbar ist, und
b) zumindest einen Hauptmagnet (4), der (4) um eine Hilfsachse (12) drehbar ist,
c) wobei das Magnetfeld (F) des Hauptmagnets (4) zumindest zwei Magnetfeldsensoren (6.1 bis 6.n) beeinflusst,
d) wobei die Beeinflussung des Magnetfeldes (F) bei den Magnetfeldsensoren (6.1 bis 6.n) durch mit einer magnetischen Feldstärke (H) des Magnetfeldes (F) und/oder einer Änderung der magnetischen Feldstärke (H) und/oder einer Polarisierung des Magnetfeldes (F) korrelierte Signale (A1, D1, PWM) ausgebbar ist,
**dadurch gekennzeichnet, dass**
e) der kontaktlose Schalter (1) einen Infrarot-Transceiver (15) aufweist, wobei der Infrarot-Transceiver (15) mittig zur Drehachse (13) und in unmittelbarer Nähe zu dem Rotor (2) angeordnet ist, und
f) der kontaktlose Schalter (1) den Hauptmagnet (4) mittels des Rotors (2) über ein als Getriebe und/oder als zumindest ein Hilfsmagnet (16) zwischen dem Rotor (2) und dem Hauptmagnet (4) ausgebildetes Verbindungsglied verstellt.

2. Kontaktloser Schalter (1) nach Anspruch 1, **dadurch gekennzeichnet, dass** der Hilfsmagnet (16) um die Drehachse (13) des Rotors (2) drehbar gelagert ist und als Ringmagnet ausgebildet ist.

3. Kontaktloser Schalter (1) nach Anspruch 2, **dadurch gekennzeichnet, dass** die Magnetfeldsensoren (6.1 bis 6.n) dem auf der Hilfsachse (12) befestigten Hauptmagneten (4) zugewandt sind und der Hauptmagnet (4) durch den um die Drehachse (13) drehbaren Hilfsmagneten (16) bewegbar ist, wobei die Drehachse (13) und die Hilfsachse (12) in einer Flucht liegen.

4. Kontaktloser Schalter (1) nach einem der vorhergehenden Ansprüche, **dadurch gekennzeichnet, dass** vier Magnetfeldsensoren (6.1 bis 6.4) vorgesehen sind, die zueinander um 90° versetzt auf dem Umfang eines gedachten Kreises (9) angeordnet sind.

5. Kontaktloser Schalter (1) nach Anspruch 4, **dadurch gekennzeichnet, dass** der Hauptmagnet (4) über dem Mittelpunkt des gedachten Kreises (9) zentriert ist und eine angulare Position des Rotors (2) durch die Polarisierung und/oder magnetische Feldstärke (H) des Magnetfeldes (F) vom Hauptmagnet (4) an zumindest zweien der Magnetfeldsensoren (6.1 bis 6.4) ermittelbar ist.

6. Kontaktloser Schalter (1) nach einem der Ansprüche 4 oder 5, **dadurch gekennzeichnet, dass** zumindest zwei der Magnetfeldsensoren (6.1 bis 6.n) in einer integrierten Schaltung (5) integriert sind.

7. Kontaktloser Schalter (1) nach einem der vorhergehenden Ansprüche, **dadurch gekennzeichnet, dass** der Rotor (2) koaxial in einem Hilfsrotor (3) oder der Hilfsrotor (3) koaxial im Rotor (2) angeordnet ist, wobei der Rotor (2) und der Hilfsrotor (3) relativ zueinander angular und/oder axial verstellbar sind und wobei der Rotor (2) und der Hilfsrotor (3) ineinander greifend ein Gewinde oder eine Kulisse (8) aufweisen, mit dem oder der eine axiale Verstellung des Rotors (2) eine angulare Verstellung des Hilfsrotors (3) bewirkt und wobei der Hilfsrotor (3) als ein Verbindungsglied zur indirekten Verbindung des Hauptmagneten (4) mit dem Rotor (2) dient.

8. Kontaktloser Schalter (1) nach einem der vorhergehenden Ansprüche, **dadurch gekennzeichnet, dass** der Rotor (2) bei einer Drehbewegung um die Drehachse (13) in Richtung der Drehachse (13) axial verschiebbar ist.

9. Kontaktloser Schalter (1) nach einem der vorhergehenden Ansprüche, **dadurch gekennzeichnet, dass** die Signale (A1, D1, PWM) pulsweitencodiert und/oder seriell und/oder parallel ausgebbar sind.

## Claims

1. A contactless switch (1) comprising
a) an angular and/or axially adjustable rotor (2) with a key retainer, wherein the rotor (2) is rotatable around a rotational axis (13), and
b) at least one main magnet (4), which (4) is rotatable around an auxiliary axis (12)
c) wherein the magnetic field (F) of the main magnet (4) influences at least two magnetic field sensors (6.1 to 6.n)
d) wherein the influence of the magnetic field (F) on the magnetic field sensors (6.1 to 6.n) can be given by means of signals (A1, D1, PWM) which are correlated with a magnetic field strength (H) of the magnetic field (F) and/or to a change of the magnetic fled strength (H) and/or to a polarisation of the magnetic field (F),
**characterized in that**
e) the contactless switch (1) comprises an infrared transceiver (15), wherein the infrared transceiver (15) is arranged centrally to the rotational axis (13) and in direct proximity to the rotor (2), and
f) the contactless switch (1) adjusts the main magnet (4) by means of the rotor (2) using a connecting member which is designed as a gearbox and/or as at least one auxiliary magnet (16) between the rotor (2) and the main magnet (4).

2. A contactless switch (1) according to claim 1, **characterized in that** the auxiliary magnet (16) is rotatably supported around the rotational axis (13) of the rotor (2), and is designed as a ring magnet.

3. A contactless switch (1) according to claim 2, **characterized in that** the magnetic field sensors (6.1 to 6.n) face the main magnet (4) which is affixed to the auxiliary axis (12), and that the main magnet (4) can be moved by the auxiliary magnets (16) which are rotatable around the rotational axis (13), wherein the rotational axis (13) and the auxiliary axis (12) are in alignment with each other.

4. A contactless switch (1) according to any one of the preceding claims, **characterized in that** four magnetic field sensors (6.1 to 6.4) are provided which are arranged offset to each other by 90° around the circumference of a virtual circle (9).

5. A contactless switch (1) according to claim 4, **characterized in that** the main magnet (4) is centred over the central point of the virtual circle (9), and an angular position of the rotor (2) can be determined by the polarisation and/or magnetic field strength (H) of the magnetic field (F) by the main magnet (4) on at least two of the magnetic field sensors (6.1 to 6.4).

6. A contactless switch (1) according to either of claims 4 or 5, **characterized in that** at least two of the magnetic field sensors (6.1 to 6.n) are integrated in an integrated circuit (5).

7. A contactless switch (1) according to any one of the preceding claims, **characterized in that** the rotor (2) is arranged coaxially in an auxiliary rotor (3), or the auxiliary rotor (3) is arranged coaxially in the rotor (2), wherein the rotor (2) and the auxiliary rotor (3) are adjustable relative to each other angularly and/or axially, and wherein the rotor (2) and the auxiliary rotor (3) grip into each other to comprise a thread or a crank (8), with which an axial adjustment of the rotor (2) creates an angular adjustment of the auxiliary rotor (3), and wherein the auxiliary rotor (3) serves as a connecting member for the indirect connection of the main magnet (4) to the rotor (2).

8. A contactless switch (1) according to any one of the preceding claims, **characterized in that** the rotor (2) can be moved axially in the direction of the rotational axis (13) with a rotational movement around the rotational axis (13).

9. A contactless switch (1) according to any one of the preceding claims, **characterized in that** the signals (A1, D1, PWM) can be given pulse-width coded and/or serially and/or parallel.

## Revendications

1. Commutateur sans contact (1), présentant
a) un rotor (2) déplaçable angulairement et/ou axialement avec un logement de clé, le rotor (2) étant pivotable autour d'un axe rotatif (13), et
b) au moins un aimant principal (4), lequel (4) est pivotable autour d'un axe auxiliaire (12),
c) le champ magnétique (F) de l'aimant principal (4) influençant au moins deux capteurs de champ magnétique (6.1 à 6.n),
d) l'influence du champ magnétique (F) pouvant être fournie par les signaux (A1, D1, PWM) en corrélation avec une force de champ magnétique (H) du champ magnétique (F) et/ou avec une modification de la force de champ magnétique (H) et/ou avec une polarisation du champ magnétique (F), aux capteurs de champ magnétique (6.1 à 6.n),
**caractérisé en ce que**
e) le commutateur sans contact (1) est un émetteur-récepteur infrarouge (15), l'émetteur-récepteur infrarouge (15) étant disposé au milieu relativement à l'axe de rotation (13) et dans le voisinage immédiat du rotor (2), et
f) le commutateur sans contact (1) déplaçant l'aimant principal (4) au moyen du rotor (2), par le biais d'un élément de liaison formé comme engrenage et/ou comme au moins un aimant auxiliaire (16) entre le rotor (2) et l'aimant principal (4).

2. Commutateur sans contact (1) selon la revendication 1, **caractérisé en ce que** l'aimant auxiliaire (16) est monté de façon pivotante autour de l'axe de rotation (13) du rotor (2) et est formé comme aimant annulaire.

3. Commutateur sans contact (1) selon la revendication 2, **caractérisé en ce que** les capteurs de champ magnétique (6.1 à 6.n) sont tournés vers l'aimant principal (4) fixé sur l'axe auxiliaire (12) et l'aimant principal (4) est déplaçable par l'aimant auxiliaire (16) pivotable autour de l'axe de rotation (13), l'axe de rotation (13) et l'axe auxiliaire (12) étant dans le prolongement l'un de l'autre.

4. Commutateur sans contact (1) selon l'une des revendications précédentes, **caractérisé en ce que** quatre capteurs de champ magnétique (6.1 à 6.4) sont prévus, lesquels sont disposés avec un décalage de 90° les uns par rapport aux autres sur la circonférence d'un cercle imaginaire (9).

5. Commutateur sans contact (1) selon la revendication 4, **caractérisé en ce que** l'aimant principal (4) est centré au moyen du centre du cercle imaginaire (9) et une position angulaire du rotor (2) est déterminable par la polarisation et/ou la force de champ magnétique (H) du champ magnétique (F) de l'aimant principal (4), au niveau d'au moins deux des capteurs de champ magnétique (6.1 à 6.4).

6. Commutateur sans contact (1) selon l'une des revendications 4 ou 5, **caractérisé en ce qu'**au moins deux des capteurs de champ magnétique (6.1 à 6.n) sont intégrés dans un circuit intégré (5).

7. Commutateur sans contact (1) selon l'une des revendications précédentes, **caractérisé en ce que** le rotor (2) est disposé coaxialement dans un rotor auxiliaire (3) ou le rotor auxiliaire (3) est disposé coaxialement dans le rotor (2), le rotor (2) et le rotor auxiliaire (3) étant déplaçables angulairement et/ou axialement l'un par rapport à l'autre, et le rotor (2) et le rotor auxiliaire (3) engagés l'un dans l'autre présentent un filet ou une coulisse (8), avec lequel ou laquelle un déplacement axial du rotor (2) entraîne un déplacement angulaire du rotor auxiliaire (3) et le rotor auxiliaire (3) servant d'élément de liaison pour la liaison indirecte de l'aimant principal (4) avec le rotor (2).

8. Commutateur sans contact (1) selon l'une des revendications précédentes, **caractérisé en ce que** le rotor (2) est déplaçable axialement par un mouvement pivotant autour de l'axe de rotation (13) en direction de l'axe de rotation (13).

9. Commutateur sans contact (1) selon l'une des revendications précédentes, **caractérisé en ce que** les signaux (A1, D1, PWM) sont délivrables avec codage par modulation de largeurs d'impulsions et/ou en série et/ou en parallèle.
